Europäisches Patentamt

European Patent Office

Office européen des brevets

(11) Numéro de publication : **0 380 167 B1**

(12) **FASCICULE DE BREVET EUROPEEN**

(45) Date de publication du fascicule du brevet :
**24.08.94 Bulletin 94/34**

(21) Numéro de dépôt : **90200130.4**

(22) Date de dépôt : **18.01.90**

(51) Int. Cl.⁵ : **H04L 27/36,** H04B 1/62

(54) ˝**Circuit de prédistorsion adaptative**˝.

(30) Priorité : **24.01.89 FR 8900813**

(43) Date de publication de la demande :
**01.08.90 Bulletin 90/31**

(45) Mention de la délivrance du brevet :
**24.08.94 Bulletin 94/34**

(84) Etats contractants désignés :
**DE FR GB IT SE**

(56) Documents cités :
**US-A- 4 291 277
THE BELL SYSTEM TECHNICAL JOURNAL,
vol. 62, no. 4, avril 1983, pages 1019-1033,
American Telephone and Telegraph Co., US;
A.A.M. SALEH et al.: ˝Adaptive linearization of
power amplifiers in digital radio systems˝**

(73) Titulaire : **LABORATOIRES D'ELECTRONIQUE
PHILIPS
3, Avenue Descartes
F-94450 Limeil-Brévannes (FR)**
㊴ **FR**
Titulaire : **N.V. Philips' Gloeilampenfabrieken
Groenewoudseweg 1
NL-5621 BA Eindhoven (NL)**
㊴ **DE GB IT SE**

(72) Inventeur : **Karam, Georges SOCIETE CIVILE
S.P.I.D.,
209, rue de l'Université
F-75007 Paris (FR)**
Inventeur : **Sari, Hikmet SOCIETE CIVILE
S.P.I.D.,
209, rue de l'Université
F-75007 Paris (FR)**

(74) Mandataire : **Landousy, Christian et al
Société Civile S.P.I.D.
156, Boulevard Haussmann
F-75008 Paris (FR)**

## Description

L'invention concerne un circuit de prédistorsion adaptative pour système de transmission numérique qui transmet des données d'entrée à la cadence d'une horloge symbole de période T à l'aide d'un modulateur et d'un amplificateur de puissance qui distord les données, le circuit comprenant :

. un circuit de prédistorsion qui prédistord en sens opposé les données d'entrée avant leur passage dans l'amplificateur afin de transmettre les données d'entrée attendues,

. un circuit d'adaptation qui à partir d'une démodulation du flux de données transmises adapte continûment le circuit de prédistorsion au flux des données d'entrée,

. et un filtre opérant une mise en forme du signal.

L'invention trouve ses applications dans les systèmes de transmission numérique tels que les modems de transmission de données, les faisceaux hertziens, les systèmes de communications spatiales.

Pour une utilisation efficace du spectre disponible, les systèmes de transmission numérique actuels, notamment les faisceaux hertziens et les systèmes de transmission de données sur le canal téléphonique, utilisent des modulations à grands nombres d'états de phase et d'amplitude. Or ces modulations sont très sensibles à toute sorte de distorsion, et bien entendu, aux distorsions non linéaires provenant des amplificateurs, des mélangeurs et d'autres circuits non-linéaires de la chaîne de transmission. Un point particulièrement critique en faisceaux hertziens et en transmission par satellite est la non-linéarité de l'amplificateur de puissance d'émission ou de l'amplificateur de puissance embarqué dans le cas des transmissions par satellite. Ces amplificateurs sont connus pour leurs caractéristiques non-linéaires. Si on les utilise dans leur zone linéaire on ne bénéficie pas totalement de leur puissance. Si on les fait fonctionner proche de leur puissance de saturation, ils distordent le signal d'une façon inacceptable. En pratique, étant donné un amplificateur de puissance, on fixe le niveau du signal émis de façon à établir un compromis entre le rapport signal à bruit et la distorsion non-linéaire subie par le signal. Ainsi le point de fonctionnement optimal de l'amplificateur est celui minimisant les effets conjoints du bruit additif du canal et de la distorsion non-linéaire de l'amplificateur. Pour des modulations à grand nombre d'états (MAQ64 et MAQ256 par exemple), ce point est loin de la puissance de saturation de l'amplificateur, ce qui signifie que celui-ci n'est pas utilisé d'une façon efficace. Pour augmenter son efficacité, on utilise couramment des techniques de prédistorsion (fixe ou adaptative) qui permettent de réduire l'effet de la non-linéarité de l'amplificateur de puissance sur le signal émis.

Une technique de prédistorsion couramment utilisée consiste à placer à l'étage de fréquence intermédiaire de l'émetteur un circuit non-linéaire approchant la fonction inverse de l'amplificateur de puissance dont on vise à compenser les non-linéarités. Si l'on savait synthétiser l'inverse exact de la fonction de l'amplificateur, cette technique permettrait d'avoir un signal parfait en sortie (sans aucune distorsion non-linéaire). Toutefois, ceci n'est pas réalisable, car l'inverse exact nécessiterait un circuit de complexité infinie. En pratique, on se contente de faire une approximation et le plus souvent on limite à l'ordre 3 la série de Taylor représentant la fonction non-linéaire de l'amplificateur et on synthétise un circuit de prédistorsion, également d'ordre 3, tel que les deux circuits cascadés n'aient plus de distorsion d'ordre 3. Des termes d'ordres supérieurs (ordre 5 et ordre 7) apparaissent en sortie mais de faible amplitude comparés à la distorsion d'ordre 3 initiale. Il en résulte ainsi une certaine amélioration des performances du système. Un inconvénient de ces circuits de prédistorsion à l'étage de fréquence intermédiaire réside dans le fait que ce sont des circuits analogiques. Ils sont difficiles à rendre adaptatifs et nécessitent de temps à autre une intervention pour les réajuster et compenser les variations de la réponse de l'amplificateur avec le temps et avec la température. Cette technique de prédistorsion est en outre à exclure si l'on veut faire une commande automatique de puissance d'émission.

Une autre technique de prédistorsion, plus récente, consiste à modifier l'alphabet des données à émettre. Cette technique appelée "prédistorsion de données" ou "prédistorsion en bande de base" est connue du document brevet US 4 291 277 et de l'article de A.A.M. SALEH et J. SALZ "Adaptive linearization of power amplifiers in digital radio systems" Bell System Technical Journal Vol. 62 Avril 1983, pages 1019-1033.

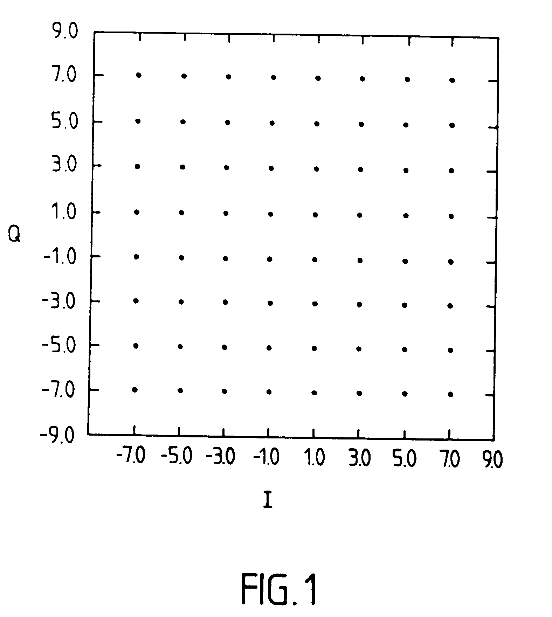

Dans l'article de A.A.M. SALEH et J. SALZ, la figure 1 est un schéma d'un circuit de prédistorsion adaptative qui fournit à l'entrée du modulateur une constellation distordue à partir de la constellation carrée d'origine, par exemple d'une modulation d'amplitude de deux porteuses en quadrature MAQ. L'amplificateur agit sur la constellation en produisant une nette compression et une nette rotation des points de grande amplitude. Pour compenser cet effet, la constellation d'origine est distordue de sorte qu'elle reprend sa forme carrée originelle après son passage dans l'amplificateur de puissance. Ainsi, lorsque le circuit de distorsion est optimisé, il forme l'inverse de l'amplificateur de puissance (à un gain et à une phase près) et permet de compenser parfaitement les non-linéarités de l'amplificateur. Pour rendre ce circuit adaptatif, le signal est repris à la sortie de l'amplificateur, démodulé, puis échantillonné à la cadence d'émission des symboles 1/T et on compare ces échantillons au point correspondant de la constellation MAQ utilisée. Ces comparaisons permettent d'obtenir un signal de commande permettant d'optimiser le circuit de prédistorsion à l'aide d'un algorithme classique.

Toutefois, le schéma utilisé sur cette figure 1 est très simpliste, car il ne dispose d'aucun filtrage avant le modulateur, ni avant l'amplificateur de puissance. Il ne correspond donc pas à la solution généralement utilisée. En effet dans les systèmes réels (voir le document brevet US 4 291 277), on utilise toujours un filtrage de mise en forme spectrale de type Nyquist permettant de limiter la bande du signal tout en garantissant une interférence intersymbole nulle aux instants de décision. Ce filtrage est en général partagé équitablement entre l'émission et la réception pour maximiser le rapport signal à bruit également aux instants de décision. Dans de tels systèmes, l'effet de la non-linéarité de l'amplificateur est double: la constellation est non seulement déformée mais il apparaît une interférence intersymbole qui associe à chaque point de la constellation un nuage de points. Or, la technique de prédistorsion décrite ci-dessus ne permet pas de compenser ce deuxième effet.

Le but de l'invention est de réaliser un circuit de prédistorsion adaptative qui permette non seulement de corriger la constellation mais aussi de réduire considérablement la dispersion de chaque point de la constellation d'origine en un nuage de points et également d'assurer à la réception une protection élevée contre l'interférence des canaux adjacents.

Selon l'invention, ce but est atteint au moyen d'un circuit de prédistorsion adaptative tel que décrit dans le préambule caractérisée en ce que le circuit comprend un circuit de codage qui, à partir des données numériques $a_k$ (k entier), génère :

    . sur une première voie, des données numériques $b_k$ qui sortent prédistordues d'un premier circuit de prédistorsion, selon des données numériques $b'_k$ en phase avec l'horloge symbole,

    . sur une seconde voie, des données numériques $c_k$ qui sortent prédistordues d'un second circuit de prédistorsion, selon des données numériques $c'_k$ déphasées de T/3 avec l'horloge symbole,

    . sur une troisième voie, des données numériques $d_k$ qui sortent prédistordues d'un troisième circuit de prédistorsion selon des données numériques $d'_k$ déphasées de 2T/3 avec l'horloge symbole,

les signaux $b_k$, $c_k$ et $d_k$ étant obtenus aux instants kT, kT+T/3, kT+2T/3 par un codage polynomial d'ordre n de type $F(D)=(1+D)^n$ où D est un opérateur retard de 2T/3, le codage étant associé à un filtrage passe-bas idéal de bande (-3/(4T), 3/(4T)), l'ensemble codage plus filtrage agissant sur les données $a_k$ selon un filtrage de mise en forme fréquentielle donné par la fonction de transfert :

$$H(\omega) = \cos^n(\omega T/3) \text{ pour } |\omega| \leq 3\Pi/2T$$

où n est un entier positif,

les données prédistordues des trois voies étant additionnées dans un circuit d'addition puis transformées en un signal analogique par un convertisseur numérique-analogique puis filtrées par le filtre passe-bas de sortie dont la fonction de transfert idéal vaut 1 pour f<3/(4T) et zéro pour f>9/(4T), où f est la fréquence, puis transmises au modulateur puis à l'amplificateur, les données émises étant démodulées puis numérisées afin de réaliser l'adaptation à l'aide de trois circuits d'adaptation qui opèrent l'un en phase et les autres déphasés de T/3 et de 2T/3 avec l'horloge symbole pour adapter chacun le circuit de prédistorsion correspondant.

Selon un premier mode de réalisation, le circuit de codage détermine les données $b_k$, $c_k$ et $d_k$ tel que :

$$b_k = \sum_{i=-J}^{J} h_{i,o} \cdot a_{k-i} \text{ avec } h_{i,o} = h(iT)$$

$$c_k = \sum_{i=-J}^{J} h_{i,1} \cdot a_{k-i} \text{ avec } h_{i,1} = h(iT+T/3)$$

$$d_k = \sum_{i=-J}^{J} h_{i,2} \cdot a_{k-i} \text{ avec } h_{i,2} = h(iT+2T/3)$$

où $h_{i,o}$, $h_{i,1}$ et $h_{i,2}$ sont des coefficients issus de la réponse impulsionnelle h(t) du filtre $H(\omega)$ caractérisant la mise en forme spectrale d'émission, et où (2J+1).T est la longueur de troncature de la réponse impulsionnelle h(t).

Selon une première variante du premier mode de réalisation, le circuit de codage peut comprendre une batterie de registres à décalage à I étages, où I=2J+1, dans lesquels circulent les données $a_k$, $a_{k-1}$, $a_{k-2}$...$a_{k-I}$, qui sont utilisées pour adresser au moins une mémoire qui opère le codage des données $a_k$ en données $b_k$, $c_k$ et $d_k$.

Selon une seconde variante du premier mode de réalisation, le circuit de codage peut être un filtre transversal qui comprend une batterie de registres à décalage à I étages dans lesquels circulent les données $a_k$,

$a_{k-1}$, $a_{k-2}$...$a_{k-l}$ qui sont multipliées :

   . sur une première voie, respectivement par les coefficients $h_{i,0}$, les produits étant additionnés pour délivrer les données $b_k$,

   . sur une seconde voie, respectivement par les coefficients $h_{i,1}$, les produits étant additionnés pour délivrer les données $c_k$,

   . sur une troisième voie, respectivement par les coefficients $h_{i,2}$, les produits étant additionnés pour délivrer les données $d_k$.

Selon un second mode de réalisation, pour opérer le codage polynomial, le circuit de codage comprend un filtre analogique d'émission de fonction de transfert $H(\omega)$, la sortie du filtre d'émission étant reliée à trois échantillonneurs opérant respectivement aux instants $kT$, $kT+T/3$ et $kT+2T/3$ chacun étant réuni à un convertisseur analogique-numérique pour délivrer respectivement les données numériques $b_x$, $c_k$, $d_k$.

Le circuit d'addition peut être constitué par un multiplexeur qui prélève les données prédistordues $b'_k$, $c'_k$ et $d'_k$ selon leur cadence propre pour les transmettre au modulateur.

Les trois voies d'adaptation peuvent être munies chacune avant les circuits d'adaptation, d'un convertisseur analogique-numérique précédé d'un échantillonneur.

Préférentiellement les circuits de prédistorsion sont des mémoires vives qui délivrent les valeurs prédistordues à la voie en phase à $1/T$ et aux voies déphasées.

Pour opérer avec un signal émis filtré qui correspond à la situation généralement mise en oeuvre, il est nécessaire d'opérer les corrections à plus d'un point par durée symbole. D'autre part, pour améliorer la protection contre l'interférence des canaux adjacents il est nécessaire de réduire la bande occupée par le signal émis à moins de $1/T$. Or il n'existe pas de filtrage garantissant à la fois une bande inférieure à $1/T$ et des niveaux discrets du signal de sortie plus d'une fois par durée symbole. Selon l'invention, on effectue un filtrage qui garantit la protection contre l'interférence entre canaux et qui permet de réaliser une prédistorsion à plus d'un point par durée symbole. Pour cela, on utilise un filtrage de bande $(-3/4T, 3/4T)$ qui assure des niveaux quasi-discrets du signal de sortie du filtre à des instants espacés de $T/3$ puis l'on transforme les niveaux quasi-discrets en niveaux discrets.

Ainsi, grâce à l'invention, il est possible de réaliser une correction du signal en trois points par durée symbole et d'atteindre en même temps une protection contre l'interférence des canaux adjacents de 30dB environ dans les faisceaux hertziens à 2x140 Mbit/sec utilisant une modulation MAQ256 et fonctionnant dans des plans de fréquences avec un espacement entre canaux de 40 MHz. De même, cette protection peut atteindre 60dB dans les faisceaux hertziens à 140 Mbit/sec utilisant une MAQ64 et fonctionnant dans des plans de fréquence avec un espacement entre canaux de 30 MHz. Ceci permet une réutilisation des fréquences.

Les signaux sont obtenus par un codage polynomial de type :

$$(1) \qquad F(D) = \sum_{i=0}^{n} f_i . D^i$$

où $D$ est un opérateur de retard de valeur $2T/3$, le codage étant suivi d'un filtrage passe-bas idéal de bande $(-3/4T, 3/4T)$. Les signaux ainsi obtenus passent par un nombre fini de niveaux quasi-discrets à tout instant $kT/3$ c'est-à-dire en trois points par durée symbole. Les polynômes conformes à la relation (1) qui sont les plus intéressants sont ceux qui localisent l'énergie du signal aux basses fréquences (pour minimiser l'interférence entre canaux adjacents). Les plus appropriés sont ceux qui peuvent être exprimés sous la forme :

$$(2) \qquad F(D) = (1 + D)^n$$

où $n$ est un entier positif. Le paramètre $n$ (avec l'alphabet de départ) détermine le nombre d'états que peut prendre le signal aux instants $kT/3$. Le paramètre $n$ ne doit pas être choisi trop grand pour limiter ce nombre d'états. Un tel codage, suivi d'un filtrage passe-bas idéal de bande $(-3/4T, 3/4T)$ donne :

$$(3) \qquad H(\omega) = \begin{cases} \cos^n(\omega T/3), & |\omega| \leqslant 3\pi/2T \\ 0, & \text{ailleurs} \end{cases}$$

pour le spectre du signal émis.

Après le filtrage passe-bas le signal prend un nombre fini de niveaux quasi-discrets. En tronquant la réponse impulsionnelle $h(t)$ à un nombre fini d'échantillons (cas du premier mode de réalisation) ou en faisant une conversion analogique-numérique à N bits du signal de sortie du filtre $H(\omega)$ tous les $T/3$ (cas du second mode de réalisation), le signal prend un nombre fini d'états donnés par l'alphabet :

   . des symboles $b_k$ aux instants $kT$

. des symboles $c_k$ aux instants kT+T/3

. des symboles $d_k$ aux instants kT+2T/3.

Ainsi la classe de filtrage de mise en forme d'émission proposée définit trois constellations. Le signal prend successivement les niveaux de chaque constellation aux instants kT, kT+T/3, kT+2T/3.

Le filtrage passe-bas qui suit l'opération de prédistorsion à l'émission n'est pas obligé d'approcher le filtre passe-bas idéal de bande (-3/4T, 3/4T) :

Il peut être de la forme :

$$G(\omega) = \begin{cases} 1, & |\omega| \leqslant 3\pi/2T \\ \text{indifférent}, & 3\pi/2T \leqslant |\omega| \leqslant 9\pi/2T \\ 0, & \omega \geqslant 9\pi/2T \end{cases}$$

sans détruire la mise en forme d'émission.

L'invention sera mieux comprise à l'aide des figures suivantes données à titre d'exemples non limitatifs qui représentent :

figure 1 : la constellation d'une modulation MAQ64.

figure 2A : une constellation MAQ64 distordue par l'amplificateur de puissance dans un système sans filtrage ou dans le cas où tout le filtrage est effectué après l'étage de l'amplificateur.

figure 2B : une constellation prédistordue optimisée pour compenser la distorsion illustrée sur la figure 2A selon l'art antérieur.

figure 3A : la constellation distordue par l'amplificateur telle qu'elle apparaît lorsque le filtrage global est équitablement partagé entre l'émission et la réception et la partie à l'émission est placée avant l'amplificateur.

figure 3B : la constellation distordue avec la même situation que celle de la figure 3A, mais en incorporant le circuit de prédistorsion de l'art antérieur.

figure 4 : une courbe de réponse impulsionnelle du filtrage d'émission (codage suivi du filtrage passe-bas) selon l'invention dans le cas où n=1.

figure 5 : un schéma de principe d'un circuit de prédistorsion adaptative selon l'invention selon le premier mode de réalisation.

figure 6 : un schéma détaillé de la première variante de réalisation du circuit de codage selon le premier mode de réalisation à l'aide d'une mémoire.

figure 7 : un schéma détaillé de la seconde variante de réalisation du circuit de codage selon le premier mode de réalisation avec des filtres transversaux dans le cas où n=1 et avec une troncature à 15 échantillons.

figure 8 : un schéma de principe d'un circuit de prédistorsion adaptative selon l'invention selon un second mode de réalisation.

figure 9 : un schéma des échantillonneurs de la boucle d'adaptation.

La figure 1 est un rappel de la représentation de la constellation d'un signal de type MAQ64. Les entrées I (en phase) et Q (en quadrature) du modulateur sont indépendantes et les symboles sur chaque voie prennent leurs valeurs dans un alphabet (±d, ±3d, ±5d, ±7d), où 2d est la distance minimale entre deux points adjacents de la constellation.

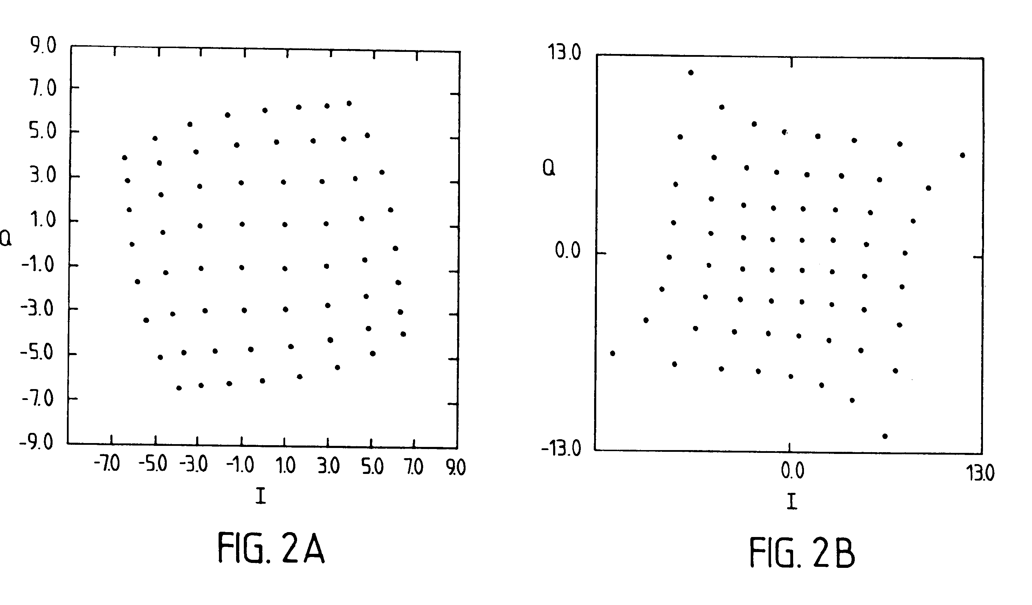

Pour être transmis le signal issu du modulateur est introduit dans un amplificateur de puissance qui est généralement utilisé à puissance réduite, c'est-à-dire dans une partie linéaire de sa caractéristique. A forte puissance cet amplificateur est non-linéaire et distord le signal de manière inacceptable. Si l'on observe une constellation de type MAQ64 à la sortie d'un tel amplificateur opérant proche de la saturation, on observe une constellation distordue comme celle représentée sur la figure 2A. Selon l'art antérieur il suffit alors de prédistordre dans le sens opposé la constellation selon le schéma de la figure 2B pour que en sortie de l'amplificateur on obtienne la constellation d'origine non déformée. Or une situation aussi simple n'est pas conforme à la réalité où il existe toujours un filtrage avant l'amplificateur de puissance notamment pour limiter la bande du signal. En absence de filtrage, le signal à l'entrée du modulateur varie par paliers une fois par durée symbole T. Ainsi, un circuit de prédistorsion agissant sur le signal à cadence 1/T permet une compensation parfaite. Par contre, lorsque le signal est filtré, il ne varie plus par paliers mais d'une façon continue. Pour une compensation parfaite de l'effet de la non-linéarité, il ne suffit plus d'observer le signal une fois par durée symbole T et de compenser la distorsion à ces moments là.

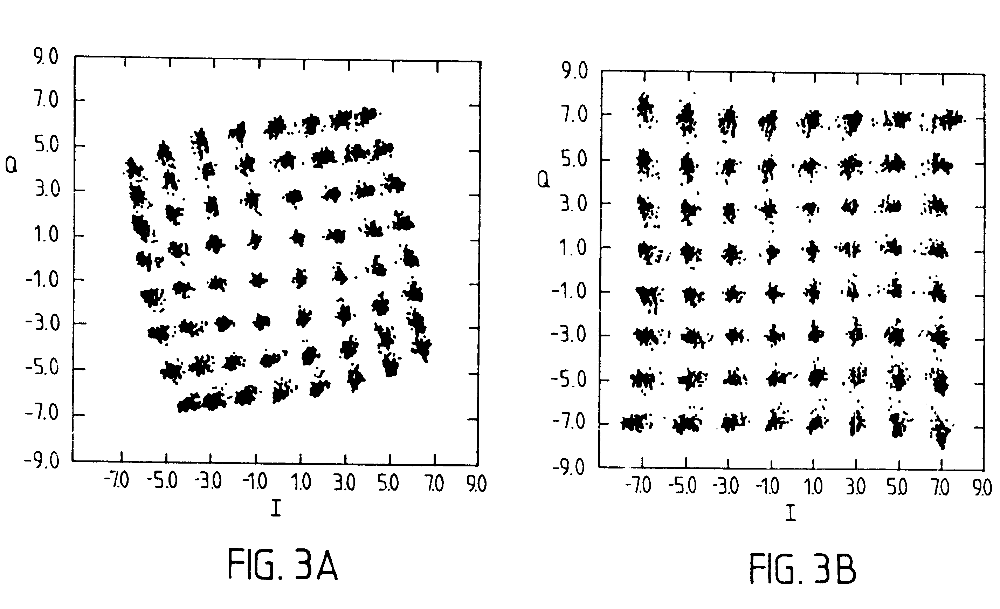

En présence d'un signal filtré la constellation à la sortie de l'amplificateur est représentée sur la figure 3A. Elle devient telle que représentée sur la figure 3B avec le circuit de prédistorsion de l'art antérieur. Ainsi chaque point de la constellation devient un nuage de points ce qui est inacceptable. Pour opérer avec un signal filtré il faut donc opérer la correction à plus d'un point par durée symbole. Pour cela selon l'invention on fait subir un codage approprié au signal d'entrée de façon à former des alphabets aux instants kT, kT+T/3 et kT+2T/3, une prédistorsion est ensuite effectuée séparément sur chacun des trois alphabets. Le signal résultant est ensuite filtré par un filtre passe-bas $G(\omega)$. Selon l'invention ces moyens de codage et de filtrage cascadés doivent présenter une réponse impulsionnelle ayant des passages par zéro à tout instant T+2kT/3 lorsque k>0 et -T+2kT/3 lorsque k<0.

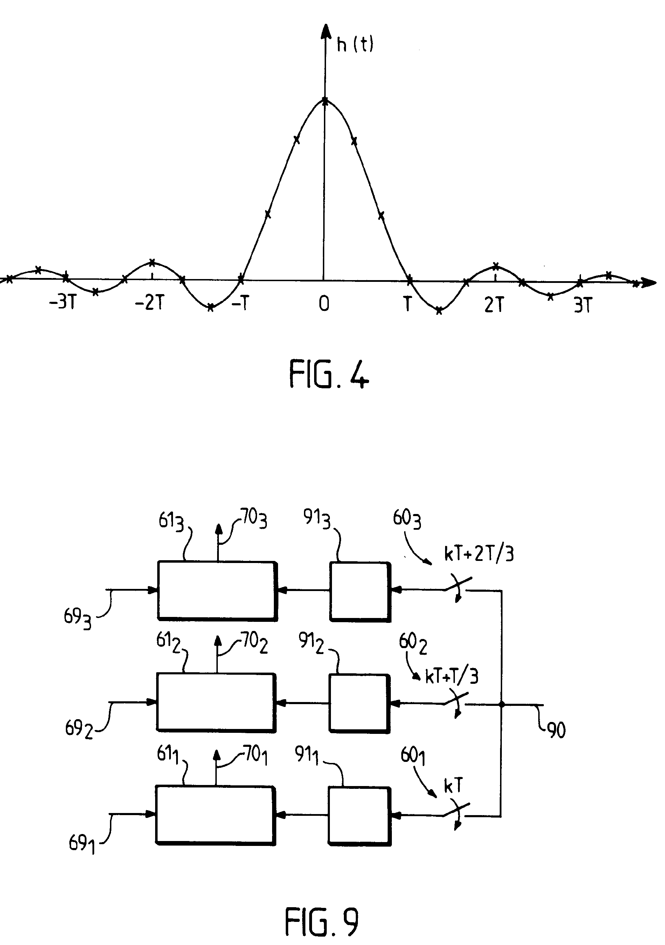

La figure 4 représente la réponse impulsionnelle du type de filtrage selon l'invention dans le cas où n=1. On observe que la courbe passe par zéro aux instants précités. Ceci permet d'obtenir des niveaux de sortie quasi-discrets avec un échantillonnage tous les T/3. Ces niveaux quasi-discrets sont transformés en niveaux discrets selon l'un ou l'autre mode de réalisation. La compensation de la non linéarité est ainsi très efficace et on obtient en sortie un signal avec peu de distorsion.

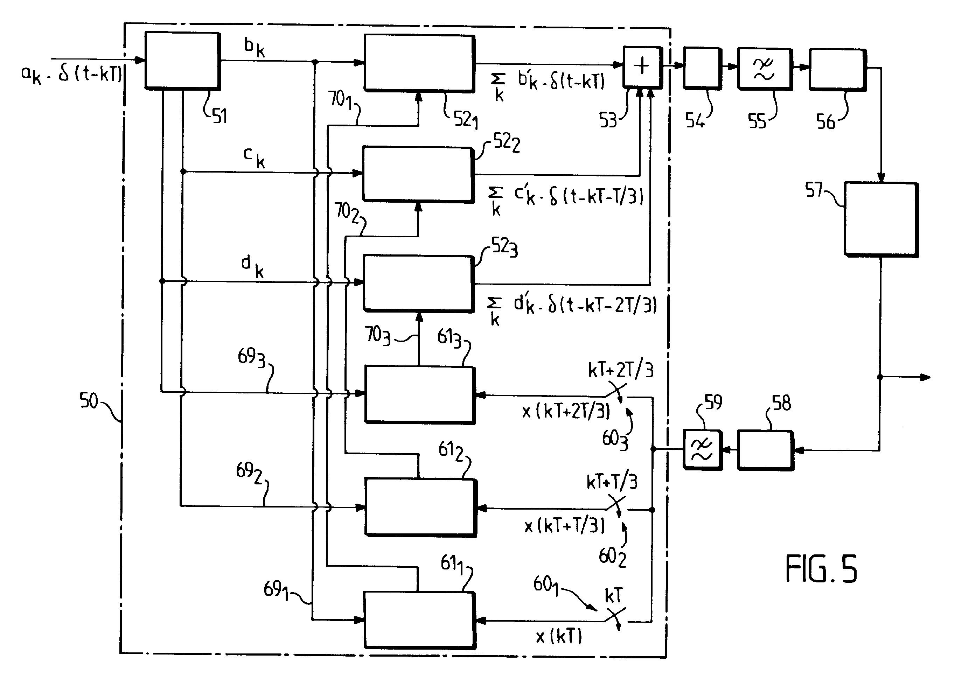

La figure 5 représente le schéma de principe de la partie située à l'émission d'un système de transmission numérique munie d'un circuit de prédistorsion adaptative 50 selon l'invention. Il comprend un circuit de codage 51 qui à partir des données $a_k$ génère des données $b_k$, $c_k$ et $d_k$ correspondant respectivement au signal d'émission échantillonné aux instants kT, kT+T/3 et kT+2T/3. Ces données $b_k$, $c_k$ et $d_k$ entrent respectivement dans des circuits de prédistorstion $52_1$, $52_2$, $52_3$ qui délivrent respectivement des signaux de données prédistordues

$$\sum_k b'_k . \delta(t-kT), \quad \sum_k c'_k . \delta(t-kT-T/3)$$

et

$$\sum_k d'_k . \delta(t-kT-2T/3),$$

où $\delta$ est la fonction de Dirac.

Ils sont additionnés dans l'additionneur 53. Le signal ainsi obtenu traverse un convertisseur numérique-analogique 54, un filtre passe-bas 55, un modulateur 56 et un amplificateur de puissance 57 puis est transmis à une antenne d'émission. Pour assurer l'adaptation, la sortie de l'amplificateur 57 est démodulée dans un démodulateur 58 puis filtrée dans un filtre passe-bas 59. La sortie du filtre 59 est échantillonnée par trois échantillonneurs, le premier $60_1$ aux instants kT, le second $60_2$ aux instants kT+T/3 et le troisième $60_3$ aux instants kT+2T/3 qui fournissent respectivement les échantillons x(kT), x(kT+T/3) et x(kT+2T/3) à trois circuits d'adaptation $61_1$, $61_2$ et $61_3$. Ceux-ci comparent respectivement les échantillons x(kT), x(kT+T/3) et x(kT+2T/3) avec les données $b_k$, $c_k$ et $d_k$. Un algorithme classique calcule par exemple l'écart entre les deux entrées de chaque circuit d'adaptation qui délivre en conséquence une mise à jour des circuits de prédistorsion.

La méthode la plus appropriée pour réaliser les circuits de prédistorsion est l'utilisation de mémoires vives RAM. Dans une telle réalisation, une RAM sera adressée par les mots $b_k$ et sa sortie constitue le train des symboles prédistordus $b'_k$. La seconde RAM sera adressée par les mots $c_k$ pour fournir le train $c'_k$. La troisième RAM sera adressée par les mots $d_k$ pour fournir le train $d'_k$. Les mémoires contiennent donc les valeurs prédistordues des alphabets respectifs.

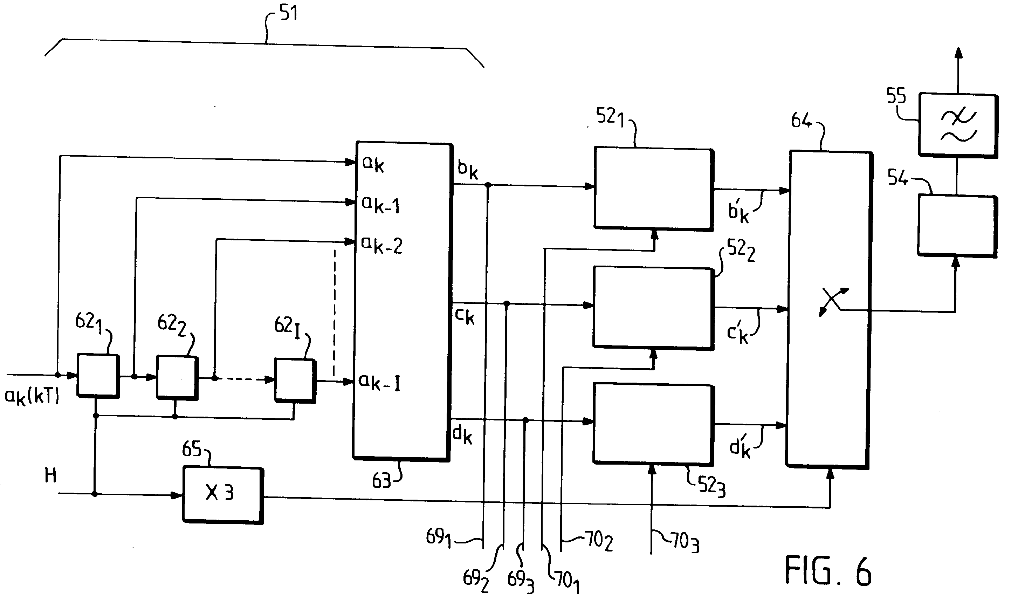

La figure 6 représente une variante de réalisation du circuit de codage 51 ne faisant pas intervenir la fonction $\delta$ qui n'est pas réalisable expérimentalement. Il comprend une batterie de N registres à décalage à I étages $62_1$, $62_2$,...$62_I$ qui à un instant donné kT stocke respectivement les données $a_{k-1}$, $a_{k-2}$,...$a_{k-I}$ sur la commande de l'horloge H=1/T (N est le nombre de bits des symboles $a_k$). La valeur de I est déterminée par la valeur de n et par la taille de la troncature de la réponse impulsionnelle. L'ensemble des données $a_k$, $a_{k-1}$,..., $a_{k-I}$ sert à adresser une mémoire 63, par exemple une mémoire morte programmable PROM qui opère le codage des données $a_k$ en données $b_k$, $c_k$ et $d_k$. Celles-ci entrent respectivement dans des mémoires vives $52_1$, $52_2$, $53_3$ qui opèrent la prédistorsion des données $b_k$ en données $b'_k$, des données $c_k$ en données $c'_k$ et des données $d_k$ en données $d'_k$, toutes trois en phase avec l'horloge symbole H=1/T. Les données $b'_k$, $c'_k$ et $d'_k$ sont alors introduites dans un multiplexeur 64 qui sélectionne successivement $b'_k$, $c'_k$ et $d'_k$ à la cadence d'une horloge de période T/3 qui est délivrée par un cadenceur 65. Dans ce cas, le multiplexeur 64 effectue ainsi l'opération d'addition opérée par le circuit d'addition 53 de la figure 5. On obtient ainsi en sortie un train de données représentent le signal r(t) avec

$$r(t) = \sum_k [b'_k . \delta(t-kT) + c'_k . \delta(t-kT-T/3) + d'_k . \delta(t-kT-2T/3)]$$

Dans ce cas, le circuit de codage 51 est constitué par la batterie de N registres à décalage à I étages $62_1$ à $62_I$ et par la mémoire 63. Ce signal numérique passe dans un convertisseur numérique-analogique 54 puis dans le filtre analogique $G(\omega)$ 55 qui précède le modulateur.

L'opération effectuée par le multiplexeur 64 qui sélectionne les données $b'_k$, $c'_k$ et $d'_k$ à des instants dis-

tants de T/3, peut également être effectuée avant les circuits de prédistorsion $52_1$, $52_2$, et $52_3$ eux-mêmes. Ceux-ci reçoivent leur mise à jour respectivement des circuits d'adaptation $61_1$, $61_2$ et $61_3$ (connexions $70_1$, $70_2$ et $70_3$, figure 5).

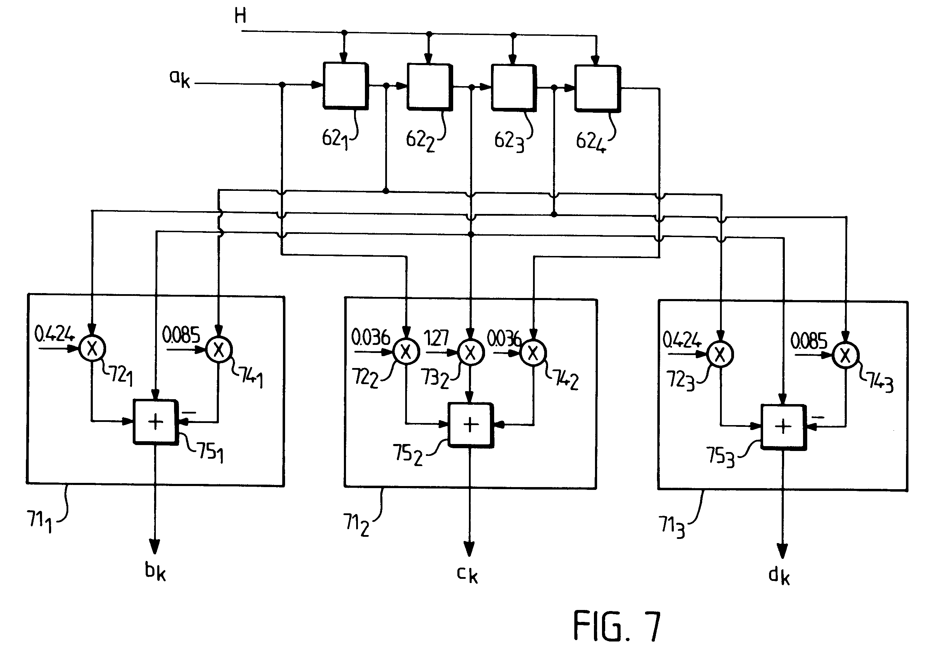

La figure 7 représente une seconde variante de réalisation du circuit de codage à partir des registres à décalage mais où la détermination des données $b_k$ $c_k$, $d_k$ est faite non pas par une mémoire comme sur la figure 6 mais où cette détermination est effectuée par un calcul direct à l'aide de filtres transversaux. Tous les autres éléments sont identiques à ceux de la figure 6. Sur la figure 7, on utilise une batterie de registres à décalage à 4 étages $62_1$ à $62_4$ qui servent à générer des données $a_k$ retardées entre-elles d'une période d'horloge. Dans cet exemple n=1 et la réponse impulsionnelle a été tronquée à 15 échantillons.

- les données $b_k$ sont obtenues par un bloc de calcul $71_1$ qui comprend :
    . un multiplieur $72_1$ qui détermine $0,424a_{k-3}$
    . un multiplieur $74_1$ qui détermine $0,085a_{k-1}$
    . un additionneur $75_1$ qui détermine $0,424a_{k-3} + a_{k-2} - 0,085a_{k-1}$
- les données $c_k$ sont obtenues par un bloc de calcul $71_2$ qui comprend :
    . un multiplieur $72_2$ qui détermine $0,036a_k$
    . un multiplieur $73_2$ qui détermine $1,27a_{k-2}$
    . un multiplieur $74_2$ qui détermine $0,036a_{k-4}$
    . un additionneur $75_2$ qui détermine $0,036a_k + 1,27a_{k-2} + 0,036a_{k-4}$
- les données $d_k$ sont obtenues par un bloc de calcul $71_3$ qui comprend :
    . un multiplieur $72_3$ qui détermine $0,424a_{k-1}$
    . un multiplieur $74_3$ qui détermine $0,085a_{k-3}$
    . un additionneur $75_3$ qui détermine $0,424a_{k-1} + a_{k-2} - 0,085a_{k-3}$

Il est bien évidemment possible d'effectuer une troncature différente de la réponse impulsionnelle et d'utiliser un nombre d'étages différent pour les registres à décalage. Ainsi, en se limitant à 9 échantillons avec 2 registres à décalage dans un cas où n=2 on peut réaliser le codage en calculant :

$$b_k = 1,698a_{k-1} + a_{k-2}$$
$$c_k = 0,339a_k + 2a_{k-1} + 0,339a_{k-2}$$
$$d_k = a_k + 1,698a_{k-1}$$

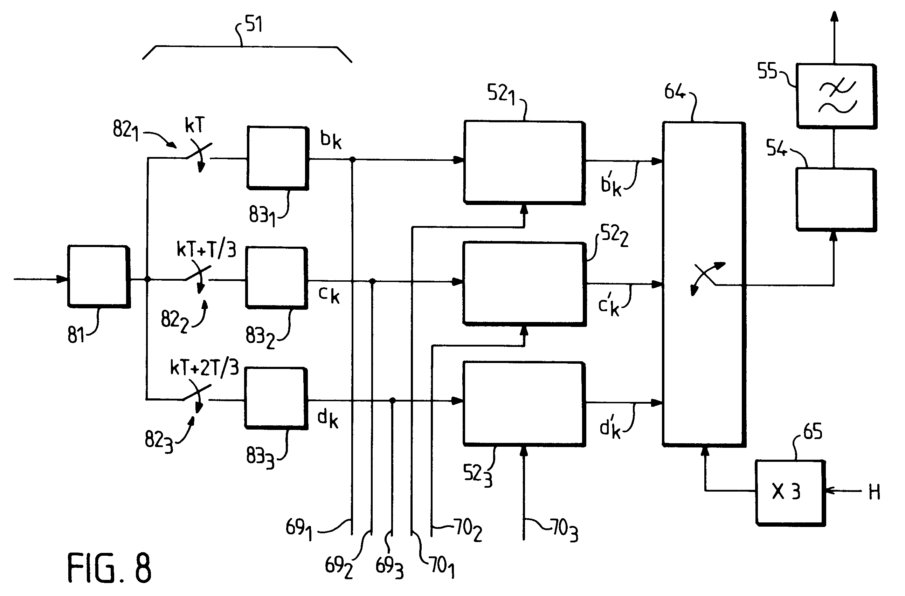

La figure 8 représente un second mode de réalisation du circuit de codage 51. Pour cela, il comprend un filtre d'émission 81, de fonction de transfert $H(\omega)$, qui réalise à la fois le codage polynomial $F(D)=(1+D)^n$ avec D=2T/3 et la fonction de filtrage passe-bas (-3T/4,3T/4). On a ainsi à la sortie de ce filtre d'émission des niveaux quasi-discrets aux temps kT, kT+T/3 et kT+2T/3. La sortie du filtre d'émission 81 est réunie à trois voies comprenant chacune un échantillonneur $82_1$, $82_2$, $82_3$ et un convertisseur analogique-numérique $83_1$, $83_2$, $83_3$, chaque voie délivrant respectivement, selon des niveaux discrets, les données $b_k$, $c_k$ et $d_k$ qui entrent dans leurs circuits de prédistorsion respectifs $52_1$, $52_2$, $52_3$. Les autres éléments sont identiques à ceux de la figure 6.

La figure 9 représente un schéma des échantillonneurs qui sont placés dans les voies d'adaptation. Le signal transmis après démodulation et filtrage arrive sur la connexion 90. Il est échantillonné par les trois échantillonneurs $60_1$, $60_2$, $60_3$ et les niveaux obtenus sont transformés en des signaux numériques par trois convertisseurs analogique-numérique $91_1$, $91_2$, $91_3$. Les signaux numériques des trois voies sont comparés respectivement aux signaux $b_k$, $c_k$, $d_k$ (connexions $69_1$, $69_2$, $69_3$) pour délivrer les signaux d'adaptation (connexions $70_1$, $70_2$, $70_3$).

Le signal émis par l'émetteur puis reçu à l'autre extrémité du système de transmission par un récepteur doit à la réception subir un filtrage qui est déterminé de façon à ce que globalement le filtrage de l'émetteur associé au filtrage du récepteur corresponde à un filtrage de Nyquist ayant un coefficient de retombée adéquat. C'est ce coefficient qui détermine la protection contre l'interférence des canaux adjacents. Pour illustrer les résultats obtenus par l'invention prenons, à titre d'exemple, un système MAQ64 à 140 Mbits/s opérant sur un plan de fréquence avec un espacement entre canaux de 30 MHz. Pour ce système, un coefficient de retombée $\alpha=0,32$ dans un filtrage de Nyquist équitablement réparti entre l'émission et la réception fournit une protection de 63,8 dB. Pour atteindre la même protection dans le système selon l'invention le filtrage global doit avoir un coefficient de retombée plus faible. Dans cet exemple le choix de n=1 comme ordre du polynôme de codage à l'émission nécessite un coefficient de retombée de 0,15 dans le filtrage global pour atteindre une protection de 63,8 dB contre l'interférence des canaux adjacents.

Selon l'invention, avec un système MAQ256 à 2x140 Mbits par seconde sur un plan de fréquences avec un espacement entre canaux de 40MHz, le gain apporté par l'invention est d'environ 3dB comparé aux techniques de prédistorsion antérieures.

7

**Revendications**

1. Circuit de prédistorsion adaptative (50 ; Fig.5) pour système de transmission numérique qui transmet des données d'entrée à la cadence d'une horloge symbole de période T à l'aide d'un modulateur et d'un amplificateur de puissance qui distord les données, le circuit comprenant :
   . un circuit de prédistorsion qui prédistord en sens opposé les données d'entrée avant leur passage dans l'amplificateur afin de transmettre les données d'entrée attendues,
   . un circuit d'adaptation qui à partir d'une démodulation du flux de données transmises adapte continûment le circuit de prédistorsion au flux des données d'entrée,
   . et un filtre de sortie opérant une mise en forme finale du signal,
   caractérisé en ce que le circuit comprend un circuit de codage (51) qui, à partir des données numériques $a_k$ (k entier), génère :
   . sur une première voie, des données numériques $b_k$ qui sortent prédistordues d'un premier circuit de prédistorsion ($52_1$), selon des données numériques $b'_k$ en phase avec l'horloge symbole,
   . sur une seconde voie, des données numériques $c_k$ qui sortent prédistordues d'un second circuit de prédistorsion ($52_2$), selon des données numériques $c'_k$ déphasées de T/3 avec l'horloge symbole,
   . sur une troisième voie, des données numérique $d_k$ qui sortent prédistordues d'un troisième circuit de prédistorsion ($52_3$) selon des données numériques $d'_k$ déphasées de 2T/3 avec l'horloge symbole,
   les signaux $b_k$, $c_k$ et $d_k$ étant obtenus aux instants kT, kT+T/3, kT+2T/3 par un codage polynomial d'ordre n de type $F(D)=(1+D)^n$ où D est un opérateur retard de 2T/3, le codage étant associé à un filtrage passe-bas idéal (55) de bande (-3/(4T), 3/(4T)), l'ensemble codage plus filtrage agissant sur les données $a_k$ selon un filtrage de mise en forme fréquentielle donné par la fonction de transfert :
   $$H(\omega) = \cos^n (\omega T/3) \text{ pour } |\omega| \leqq 3\Pi/2T$$
   où n est un entier positif,
   les données prédistordues des trois voies étant additionnées dans un circuit d'addition (53) puis transformées en un signal analogique par un convertisseur numérique-analogique (54) puis filtrées par le filtre passe-bas de sortie (55) dont la fonction de transfert idéal vaut 1 pour f<3/(4T) et zéro pour f>9/(4T), où f est la fréquence, puis transmises au modulateur (56) puis à l'amplificateur (57), les données émises étant démodulées (58) puis numérisées afin de réaliser l'adaptation à l'aide de trois circuits d'adaptation ($61_1$, $61_2$, $61_3$) qui opèrent l'un en phase et les autres déphasés de T/3 et de 2T/3 avec l'horloge symbole pour adapter chacun le circuit de prédistorsion correspondant.

2. Circuit de prédistorsion adaptative selon la revendication 1 caractérisé en ce que le circuit de codage (51) détermine les données $b_k$, $c_k$ et $d_k$ tel que :

$$b_k = \sum_{i=-J}^{J} h_{i,0} \cdot a_{k-i} \text{ avec } h_{i,0} = h(iT)$$

$$c_k = \sum_{i=-J}^{J} h_{i,1} \cdot a_{k-i} \text{ avec } h_{i,1} = h(iT+T/3)$$

$$d_k = \sum_{i=-J}^{J} h_{i,2} \cdot a_{k-i} \text{ avec } h_{i,2} = h(iT+2T/3)$$

où $h_{i,o}$, $h_{i,1}$ et $h_{i,2}$ sont des coefficients issus de la réponse impulsionnelle h(t) du filtre $H(\omega)$ caractérisant la mise en forme spectrale d'émission, et où (2J+1).T est la longueur de troncature de la réponse impulsionnelle h(t).

3. Circuit de prédistorsion adaptative selon la revendication 2, caractérisé en ce que le circuit de codage (51 ; Fig.6) comprend une batterie de registres à décalage à I étages ($62_1$, $62_2$, $62_3$), où I=2J+1, dans lesquels circulent les données $a_k$, $a_{k-1}$, $a_{k-2}$...$a_{k-I}$, qui sont utilisées pour adresser au moins une mémoire (63) qui opère le codage des données $a_k$ en données $b_k$, $c_k$ et $d_k$.

4. Circuit de prédistorsion adaptative selon la revendication 2, caractérisé en ce que le circuit de codage est un filtre tranversal qui comprend une batterie de registres à décalage à I étages ($62_1$, $62_2$, $62_3$, $62_4$; Fig.

7) dans lesquels circulent les données $a_k$, $a_{k-1}$, $a_{k-2}$...$a_{k-l}$ qui sont multipliées :
- . sur une première voie, respectivement par les coefficients $h_{i,0}$, les produits étant additionnés ($71_1$) pour délivrer les données $b_k$,
- . sur une seconde voie, respectivement par les coefficients $h_{i,1}$, les produits étant additionnés ($71_2$) pour délivrer les données $c_k$,
- . sur une troisième voie, respectivement par les coefficients $h_{i,2}$, les produits étant additionnés ($71_3$) pour délivrer les données $d_k$.

5. Circuit de prédistorsion adaptative selon la revendication 1 caractérisé en ce que le circuit de codage (51 ; Fig.8) comprend un filtre analogique d'émission (81) de fonction de transfert $H(\omega)$, la sortie du filtre d'émission étant reliée à trois échantillonneurs ($82_1$, $82_2$, $82_3$) opérant respectivement aux instants kT, kT+T/3 et kT+2T/3 chacun étant réuni à un convertisseur analogique-numérique ($83_1$, $83_2$, $83_3$) pour délivrer respectivement les données numériques $b_k$, $c_k$, $d_k$.

6. Circuit de prédistorsion adaptative selon une des revendications 1 à 5 caractérisé en ce que le circuit d'addition est constitué par un multiplexeur (64 ; Fig. 6, Fig.8) qui prélève les données prédistordues $b'_k$, $c'_k$ et $d'_k$ selon leur cadence propre pour les transmettre au modulateur.

7. Circuit de prédistorsion adaptative selon une des revendications 1 à 6 caractérisé en ce que les trois voies d'adaptation ($61_1$, $61_2$, $61_3$ ; Fig. 5) sont munies chacune, avant les circuits d'adaptation, d'un convertisseur analogique-numérique précédé d'un échantillonneur.

8. Circuit de prédistorsion adaptative selon une des revendications 1 à 7 caractérisé en ce que les circuits de prédistorsion ($52_1$, $52_2$, $52_3$ ; Fig. 5,6,8) sont des mémoires vives qui délivrent les valeurs prédistordues à la voie en phase et aux voies déphasées.

## Patentansprüche

1. Adaptive Vorverzerrungsschaltung (50; Fig. 5) für ein digitales Übertragungssystem, das Eingangsdaten im Zyklus eines Zeichentaktgebers der Periode T mittels eines Modulators und eines Leistungsverstärkers, der die Daten verzerrt, überträgt, wobei die Schaltung folgendes umfaßt:
- . eine Vorverzerrungsschaltung, die die Eingangsdaten in entgegengesetzter Richtung vor ihrem Eintritt in den Verstärker vorverzerrt, um die erwarteten Eingangsdaten zu übertragen,
- . eine Anpassungsschaltung, die anhand einer Demodulation des übertragenen Datenflusses die Vorverzerrungsschaltung kontinuierlich dem Eingangsdatenfluß anpaßt,
- . und einen Filter, der das Signal in die endgültige Form bringt,

dadurch gekennzeichnet, daß die Schaltung eine Codierschaltung (51) umfaßt, die aus den digitalen Daten $a_k$ (k ganzzahlig) folgendes erzeugt:
- . auf einer ersten Strecke digitale Daten $b_k$, welche - vorverzerrt von einer ersten Vorverzerrungsschaltung ($52_1$) - je nach den mit dem Zeichentakt phasengleichen digitalen Daten $b'_k$ ausgegeben werden,
- . auf einer zweiten Strecke digitale Daten $c_k$, welche - vorverzerrt von einer zweiten Vorverzerrungsschaltung ($52_2$) - je nach den um T/3 mit dem Zeichentakt phasenverschobenen digitalen Daten $c'_k$ ausgegeben werden,
- . auf einer dritten Strecke digitale Daten $d_k$, welche - vorverzerrt von einer dritten Vorverzerrungsschaltung ($52_3$) - je nach den um 2T/3 mit dem Zeichentakt phasenverschobenen digitalen Daten $d'_k$ ausgegeben werden,

wobei die Signale $b_k$, $c_k$ und $d_k$ in den Augenblicken kT, kT+T/3, kT+2T/3 über eine polynomische Codierung der Ordnung n vom Typ $F(D)=(1+D)^n$, worin D ein Verzögerungsoperator von 2T/3 ist, erhalten werden, die Codierung mit einer idealen Tiefpaßbandfilterung (55) (-3/(4T), 3/(4T)) verbunden ist und die Codierung und die Filterung gemeinsam gemäß einer Frequenzabstimmungsfilterung auf die Daten $a_k$ wirken, die durch die Übertragungsfunktion:

$$H(\omega) = \cos^n(\omega T/3) \text{ für } |\omega| \leq 3\pi/2T$$

worin n eine positive ganze Zahl ist, gegeben ist,

wobei die vorverzerrten Daten der drei Strecken in einer Addierschaltung (53) addiert werden, dann durch einen Digital-Analog-Umsetzer (54) in ein analoges Signal umgewandelt, dann über den Ausgangstiefpaßfilter (55), dessen ideale Übertragungsfunktion 1 für f<3/(4T) und 0 für f>9/(4T) ist, worin f die Frequenz ist, gefiltert werden, dann dem Modulator (56) und anschließend dem Verstärker (57) zugeführt werden, wobei die ausgegebenen Daten demoduliert (58) und danach digitalisiert werden, um die Anpassung mittels der drei Anpassungsschaltungen ($61_1$, $61_2$, $61_3$), von denen eine phasengleich und die anderen um T/3 und 2T/3 phasenverschoben mit dem Zeichentakt arbeiten, durchzuführen, damit jede die entsprechende Vorverzerrungsschaltung anpassen kann.

2. Adaptive Vorverzerrungsschaltung nach Anspruch 1, <u>dadurch gekennzeichnet</u>, daß die Codierschaltung (51) die Daten $b_k$, $c_k$ und $d_k$ wie folgt bestimmt:

$$b_k = \sum_{i=-J}^{J} h_{i,o} . a_{k-i} \; mit \; h_{i,o} = h(iT)$$

$$c_k = \sum_{i=-J}^{J} h_{i,1} . a_{k-i} \; mit \; h_{i,1} = h(iT+T/3)$$

$$d_k = \sum_{i=-J}^{J} h_{i,2} . a_{k-i} \; mit \; h_{i,2} = h(iT+2T/3)$$

worin $h_{i,0}$, $h_{i,1}$ und $h_{i,2}$ Koeffizienten sind, die aus dem Impulsverhalten h(t) des Filters H($\omega$), das die spektrale Sendeimpulsformung kennzeichnet, abgeleitet sind und worin (2J+1)T die Begrenzungslänge des Impulsverhaltens h(t) ist.

3. Adaptive Vorverzerrungsschaltung nach Anspruch 2, <u>dadurch gekennzeichnet</u>, daß die Codierschaltung (51; Fig. 6) eine Gruppe von Schieberegistern mit I Stufen ($62_1$, $62_2$, $62_3$) mit I=2J+ 1 umfaßt, in denen die Daten $a_k$, $a_{k-1}$, $a_{k-2}$...$a_{k-I}$ fließen, die dazu benutzt werden, mindestens einen Speicher (63), der die Codierung der Daten $a_k$ in Daten $b_k$, $c_k$ und $d_k$ vornimmt, zu adressieren.

4. Adaptive Vorverzerrungsschaltung nach Anspruch 2, <u>dadurch gekennzeichnet</u>, daß die Codierschaltung ein Querfilter ist, der eine Gruppe von Schieberegistern mit I Stufen ($62_1$, $62_2$, $62_3$, $62_4$; Fig. 7) umfaßt, in denen die Daten $a_k$, $a_{k-1}$, $a_{k-2}$...$a_{k-I}$ fließen, welche multipliziert werden:
   . auf einer ersten Strecke jeweils mit den Koeffizienten $h_{i,0}$, wobei die Produkte addiert werden ($71_1$), um die Daten $b_k$ auszugeben,
   . auf einer zweiten Strecke jeweils mit den Koeffizienten $h_{I-1}$, wobei die Produkte addiert werden ($71_2$), um die Daten $c_k$ auszugeben,
   . auf einer dritten Strecke jeweils mit den Koeffizienten $h_{i,2}$, wobei die Produkte addiert werden ($71_3$), um die Daten $d_k$ auszugeben.

5. Adaptive Vorverzerrungsschaltung nach Anspruch 1, <u>dadurch gekennzeichnet</u>, daß die Codierschaltung (51; Fig. 8) einen Analogsendefilter (81) mit Übertragungsfunktion H($\omega$) enthält, wobei der Ausgang des Sendefilters mit drei Abtastern ($82_1$, $82_2$, $82_3$) verbunden ist, wovon jeder jeweils in den Augenblicken kT, kT+T/3 und kT+2T/3 wirkt und jeder mit einem Analog-Digital-Umsetzer ($83_1$, $83_2$, $83_3$) verbunden ist, um jeweils die digitalen Daten $b_k$, $c_k$, $d_k$ auszugeben.

6. Adaptive Vorverzerrungsschaltung nach einem der Ansprüche 1 bis 5, <u>dadurch gekennzeichnet</u>, daß die Addierschaltung aus einem Multiplexer (64; Fig. 6, Fig. 8) besteht, der die vorverzerrten Daten $b'_k$, $c'_k$ und $d'_k$ nach ihrem eigenen Takt abnimmt, um sie dem Modulator zuzuführen.

7. Adaptive Vorverzerrungsschaltung nach einem der Ansprüche 1 bis 6, <u>dadurch gekennzeichnet</u>, daß jede der drei Anpassungsstrecken ($61_1$, $61_2$, $61_3$; Fig. 5) vor den Anpassungsschaltungen mit einem Analog-Digital-Umsetzer, dem ein Abtaster vorgeschaltet ist, versehen ist.

8. Adaptive Vorverzerrungsschaltung nach einem der Ansprüche 1 bis 7, <u>dadurch gekennzeichnet</u>, daß die Vorverzerrungsschaltungen ($52_1$, $52_2$, $52_3$; Fig. 5, 6, 8) Arbeitsspeicher sind, die die vorverzerrten Werte auf die phasengleiche Strecke und die phasenverschobenen Strecken übertragen.

## Claims

1. Adaptive predistortion circuit (50; Fig. 5) for a digital transmission system for sending input data at the rate of a symbol clock having a period T with the aid of a modulator and a power amplifier which distorts the data, the circuit comprising:
   - a predistortion circuit for predistorting in the opposite sense the input data prior to their entering the amplifier in order to transmit the expected input data,
   - an adaptation circuit for continuously adapting the predistortion circuit to the stream of input data in response to a demodulation of the stream of transmitted data,
   - and a filter performing a signal shaping,
   characterized in that the adaptive predistortion circuit further comprises an encoder (51) for generating, on the basis of digital data $a_k$ (k being an integer):
   - on a first path, digital data $b_k$ leaving a first predistortion circuit ($52_1$)in a predistorted condition as digital data $b'_k$ in-phase with the symbol clock,
   - on a second path, digital data $c_k$ leaving a second predistortion circuit ($52_2$) in a predistorted condition, as digital data $c'_k$ phaseshifted by T/3 with respect to the symbol clock,
   - on a third path, digital data $d_k$ leaving a third predistortion circuit ($52_3$) in a predistorted condition as digital data $d'_k$ phaseshifted by 2T/3 with respect to the symbol clock,
   the signals $b_k$, $c_k$ and $d_k$ being obtained at the instants kT, kT+T/3, kT+2T/3 by means of an n-th order polynomial encoding of the type of $F(D)=(1+D)^n$, where D is a delay of 2T/3, the encoding being associated to an ideal low-pass filtering (55) of bandwidth (-3/(4T), 3/(4T)), the encoding and filtering jointly influencing the data $a_k$ in accordance with a frequency-shaping filtering given by the transfer function:
   $$H(\omega = \cos^n(\omega T/3) \text{ for } |\omega| \leq 3\pi/(2T)$$
   where n is a positive integer,
   the predistorted data of the three paths being added together in an adder circuit (53) and then converted to an analog signal by a digital-to-analog converter (54), the analog signal being filtered by the low-pass output filter (55) whose ideal transfer function is equal to 1 for f < 3/(4T) and zero for f > 9/(4T), f being the frequency, after which it is sent to the modulator (56) and then to the amplifier (57), the sent data being demodulated (58) and then digitized so as to realize the adaptation with the aid of three adaptation circuits ($61_1$, $61_2$, $61_3$), one operating in-phase and the others phase-shifted by T/3 and 2T/3 with respect to the symbol clock for adapting each the corresponding predistortion circuit.

2. Adaptive predistortion circuit as claimed in Claim 1, characterized in that the encoder (51) determines the data $b_k$, $c_k$ and $d_k$ so that:

$$b_k = \sum_{i=-J}^{J} h_{i,0} \cdot a_{k-i}$$

$$c_k = \sum_{i=-J}^{J} h_{i,1} \cdot a_{k-i}$$

$$d_k = \sum_{i=-J}^{J} h_{i,2} \cdot a_{k-i}$$

where $h_{i,0}$, $h_{i,1}$ and $h_{i,2}$ are coefficients of the impulse response h(t) of the filter $H(\omega)$ characterizing the spectral signal shaping at the send end, and where (2J+1).T is the truncating length of the impulse response h(t).

3. Adaptive predistortion circuit as claimed in Claim 2, characterized in that the encoder (51; Fig. 6) comprises a set of shift registers having I stages ($62_1$, $62_2$, $62_3$), where I=2J+1, in which the data $a_k$, $a_{k-1}$ $a_{k-2}$ ... $a_{k-I}$ pass that are used to address at least one memory (63) which performs the encoding of the data $a_k$ into data $b_k$, $c_k$ and $d_k$.

4. Adaptive predistortion circuit as claimed in Claim 2, characterized in that the encoder is a transversal filter comprising a set of shift registers having I stages ($62_1$, $62_2$, $62_3$, $62_4$; Fig. 7) in which the data $a_k$, $a_{k-1}$ $a_{k-2}$ ... $a_{k-I}$ pass, which are multiplied:
   - on a first path by the respective coefficients $h_{i,0}$, the products being added together ($71_1$) to produce the data $b_k$,
   - on a second path by the respective coefficients $h_{i-1}$, the products being added together ($71_2$) to produce the data $c_k$,
   - on a third path by the respective coefficients $h_{i-2}$, the products being added together ($71_3$) to produce the data $d_k$.

5. Adaptive predistortion circuit as claimed in Claim 1, characterized in that the encoder (51; Fig. 8) comprises an analog send filter (81) at the transmit end having the transfer function $H(\omega)$, whose output is connected to three samplers ($82_1$, $82_2$, $82_3$) operating at the respective instants kT, kT+T/3 and kT+2T/3, which samplers are connected each to an analog-to-digital converter ($83_1$, $83_2$, $83_3$) to produce the respective digital data $b_k$, $c_k$, $d_k$.

6. Adaptive predistortion circuit as claimed in one of the Claims 1 to 5, characterized in that the adder circuit is constituted by a multiplexer (64; Fig. 6, Fig. 8) taking the predistorted data $b'_k$, $c'_k$ and $d'_k$ according to their own timing in order to send them to the modulator.

7. Adaptive predistortion circuit as claimed in one of the Claims 1 to 6, characterized in that the three adaptation paths ($61_1$, $61_2$, $61_3$; Fig. 5) each comprise an analog-to-digital converter preceded by a sampler inserted before the adaptation circuits.

8. Adaptive predistortion circuit as claimed in one of the Claims 1 to 7, characterized in that the predistortion circuits ($52_1$, $52_2$, $52_3$; Fig. 5, 6, 8) are random access memories supplying the predistorted values on the inphase path and on the two phase shifted paths.

FIG.1

FIG. 2A

FIG. 2B

FIG. 3A

FIG. 3B

EP 0 380 167 B1

FIG. 4

FIG. 9

FIG. 5

FIG. 6

EP 0 380 167 B1

FIG. 7

FIG. 8